Europäisches Patentamt

European Patent Office

Office européen des brevets

(19)

(11)  EP 1 422 814 A1

(12)  EUROPEAN PATENT APPLICATION

(43) Date of publication:
26.05.2004  Bulletin 2004/22

(51) Int Cl.7: H02M 3/156, H03K 7/08

(21) Application number: 02425707.3

(22) Date of filing: 19.11.2002

(84) Designated Contracting States:
AT BE BG CH CY CZ DE DK EE ES FI FR GB GR
IE IT LI LU MC NL PT SE SK TR
Designated Extension States:
AL LT LV MK RO SI

(71) Applicant: S.I.E.M. S.r.l.
73100 Lecce (IT)

(72) Inventor: Aguglia, Jorge Miguel
73100 - Lecce (IT)

(74) Representative: Modiano, Guido, Dr.-Ing. et al
Modiano & Associati SpA
Via Meravigli, 16
20123 Milano (IT)

(54)  **PWM control circuit particularly for low-voltage applications**

(57)    A PWM control circuit, comprising a load (13) in output to the PWM control circuit, power supply means (11) for generating a voltage value and means (12) for regulating the voltage on the load (13), characterized in that it comprises means (14) for reading the voltage on the load (13) which are connected between the load (13) and the voltage regulation means (12), the voltage regulation means (12) comprising means (21, 22) for connecting the load to the power supply means (11) at specific times, according to the voltage read by the voltage reading means (14) so as to generate a PWM voltage on the load.

Fig. 2

EP 1 422 814 A1

## Description

The present invention relates to a PWM control circuit particularly for low-voltage applications. This circuit is conceived particularly to drive lamps, but it can also be used for driving motors in which the operating voltages can reach low levels.

PWM control circuits are widely known and used in various fields of application, and typically they are more widely used in the field of electric motor driving.

In the typical configuration of these circuits, the supply voltage is sufficiently high, since it is necessary to ensure both power-on of the power devices used and driving of loads which are usually high.

When one wishes to use a PWM circuit to drive low-voltage loads, the problem arises of devising circuit solutions to keep the efficiency of the circuit as high as possible, and such solutions are often complicated.

The aim of the present invention is to provide a PWM control circuit with a wide range of applications and having a high efficiency even at low power supply voltages.

Within this aim, a particular object is to use a very low number of active components, so as to reduce the number of components that can be integrated on a chip or soldered on a board.

Another object is to avoid damage to the load for any supply voltage.

In the particular case in which the load comprises a lamp, an object is to increase the performance (meant as the ratio between duration and brightness) with respect to the case in which the lamp is powered directly.

Another object of the invention is to provide a PWM control circuit that is highly reliable, relatively easy to provide and competitive in terms of costs.

This aim and these and other objects that will become better apparent hereinafter are achieved by the PWM control circuit according to the invention, which comprises a load in output to said control circuit, power supply means for generating a voltage value and means for regulating the voltage on said load, characterized in that it comprises means for reading the voltage on said load which are connected between said load and said voltage regulation means, said voltage regulation means comprising means for connecting said load to said power supply means at specific times, according to the voltage read by said voltage reading means.

Further characteristics and advantages of the invention will become better apparent from a preferred but not exclusive embodiment of the PWM control circuit according to the invention, illustrated only by way of non-limitative example in the accompanying drawings, wherein:

Figure 1 is a general block diagram of the PWM control circuit according to the invention;
Figure 2 is a view of the execution and mutual connection of the regulation means and of the means for reading the voltage on the load;
Figure 3 is a detailed circuit diagram of a particular embodiment of the invention;
Figure 4 is a view of the embodiment of Figure 3, in which a current control block has been added;
Figure 5 is a view of the embodiment of Figure 4, further comprising a system for filtering the voltage generated on the load.

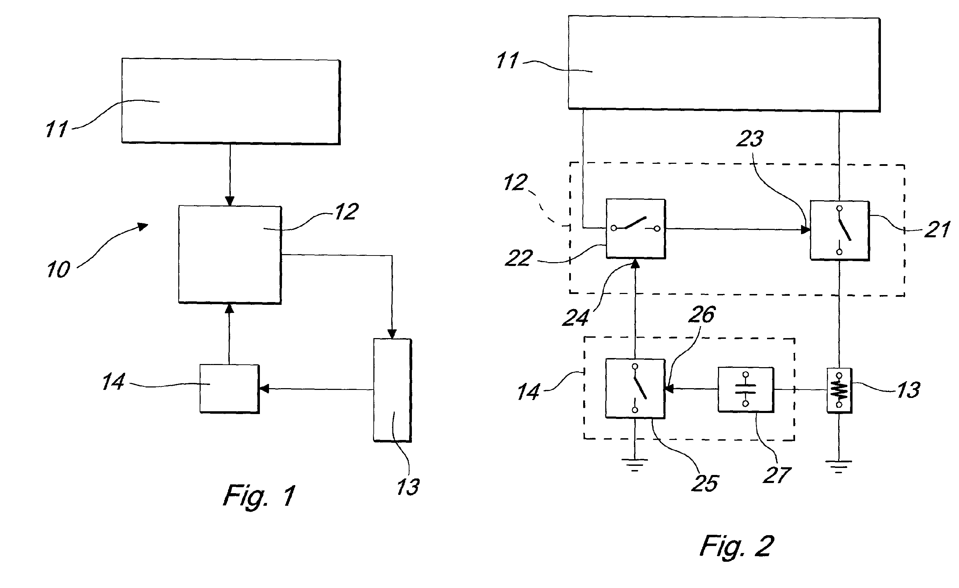

With reference to Figure 1, the PWM control circuit, generally designated by the reference numeral 10, comprises power supply means 11 for supplying power to the various components of the circuit, regulation means 12 connected to a load 13, and means 14 for reading the voltage on said load 13, which are connected between the load 13 and the regulation means 12.

In the Figures, the ground symbol designates the generic node at common potential of the circuit to which the load refers. In the description, the term "ground" refers to this common node.

The regulation means 12 comprise means for connecting the load to the power supply means 11 at preset times, particularly time-variant elements capable of switching their operating state. In the preferred embodiment, these switching elements comprise switches, which connect the load alternately to the power supply means and to the ground, depending on the time instant; this connection occurs periodically over time, so that the output voltage, applied across the load, switches between two values (high and low), producing an oscillating signal.

The oscillating signal generated in output by the circuit is a PWM signal, whose amplitude and duty cycle depend on the value of the voltage produced by the power supply means 11. If the power supply voltage is constant over time, the PWM signal on the load has a duty cycle which is constant in time.

Figure 2 shows in greater detail the composition of the regulation means 12; the means for connecting the load to the power supply means 11 comprise a first switch 21 and a second switch 22, both of the three-pole type.

Three-pole switches notoriously comprise two poles that define the terminals of the switch and an activation pole which allows to control the opening or closure of the switch, i.e., to create ideally an open circuit or a short circuit between the terminals of the switch, respectively.

The switch 21 is connected between the power supply means 11 and the load 13, and comprises a first activation pole 23 for connecting and/or disconnecting said load with respect to the power supply means 11. The load 13 is connected to one of the two terminals of the switch 21.

The first activation pole 23 is instead connected to one of the terminals of the second switch 22, so that the switching of the state of the switch 22 entails a switching of the state of the switch 21. The switch 22 also comprises a second activation pole 24 for opening or closing said switch 22.

The load 13 is further connected to the reading means 14, which in turn are connected to the second activation pole 24 of the switch 22, so that the switch 22 is switched according to the voltage value read by the reading means 14. In particular, the reading means 14 comprise a third switch 25 that has a plurality of poles: in the preferred embodiment, the switch 25 comprises a third activation pole 26 for opening or closing said switch 25.

The connection between the load 13 and the reading means 14 is provided by means of the third activation pole 26 and by way of capacitive means 27 connected to the ground, so that when the voltage across the load 13 reaches a certain value for a certain time interval, the state of the switch 25 is switched.

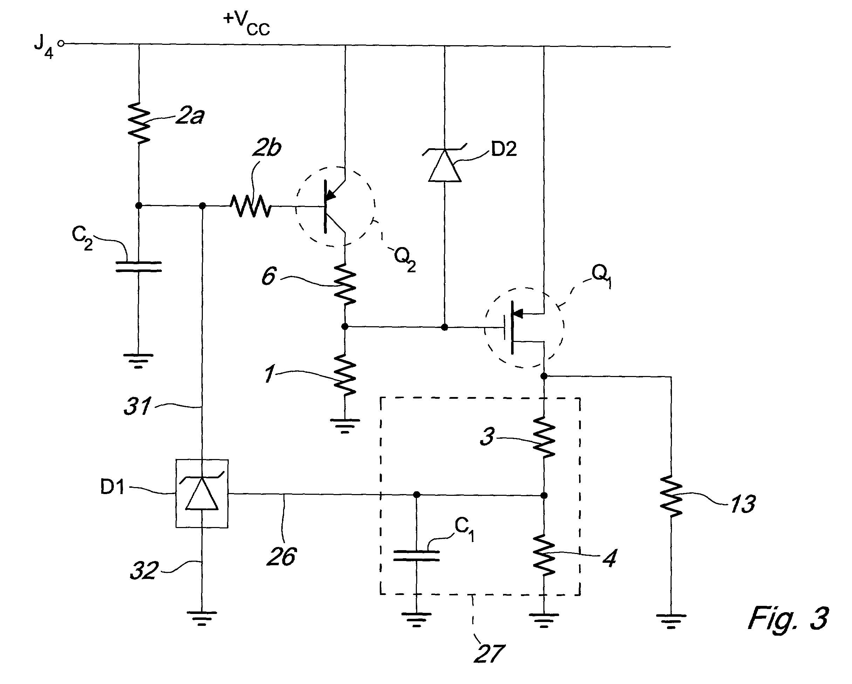

The components shown in general form in Figure 2 are shown in greater detail in Figure 3, to which reference is now made.

The power supply means 11 comprise a positive voltage source Vcc, and the load 13 is shown as a resistor having a resistance $R_L$: said load can be for example a lamp.

The first switch 21 comprises a p-channel MOSFET transistor Q1, for example a power MOSFET, in which the source terminal is directly connected to the voltage source Vcc and the drain terminal is connected directly to the load 13. The first activation pole 23 coincides with the gate terminal of the MOSFET Q1 and is connected to the ground across a first resistive means 1.

In the case of a low-power circuit, the power MOSFET can be replaced with a signal MOSFET.

The second switch 22 comprises a bipolar transistor Q2 of the p-n-p type, in which the emitter terminal is directly connected to the voltage source Vcc and the collector terminal is connected to the gate terminal of Q1 by means of a resistor 6. The second activation pole 24 coincides with the base terminal of Q2, which is connected to the voltage source Vcc by means of a second resistive means, which comprises a series of two resistors 2a and 2b.

The third switch 25 comprises a Zener diode device D1, which has a first terminal 31, a second terminal 32 and a reference terminal that coincides with the third activation pole 26. The device D1 is, in particular, a voltage reference integrated circuit of the programmable type, which has a cathode terminal that coincides with said first terminal 31 and an anode terminal that coincides with said second terminal 32. A programmable voltage reference is, for example, TL431 by ST Microelectronics, which absorbs current when the reference terminal is at approximately 2.5 V with respect to the potential of the anode terminal. In order to operate correctly, the TL431 must have a certain cathode current, which in the embodiment shown in Figure 3 is ensured by the resistor 2a.

The cathode terminal 31 is connected to the base terminal of Q2; in particular, it is connected between the two resistors 2a and 2b; the anode terminal 32 is instead connected to the ground.

The reference terminal 26 is connected to the load 13 by means of the capacitive means 27, which comprise at least one first capacitor C1 and resistive means, in particular a third resistive means 3 and a fourth resistive means 4. The resistive means are connected so that the capacitor C1 and the fourth resistive means 4 are in parallel to each other and are connected between the reference terminal 26 and the ground; the third resistive means 3 is instead in series to said parallel configuration between the capacitor C1 and the fourth resistive means 4, and is connected between the load 13 and the capacitor C1. On the basis of the preceding description and with reference to Figure 3, the third resistive means 3 is therefore connected to the drain terminal of the MOSFET Q1.

The circuit is completed with a second capacitor having a capacitance C2, which is connected between the resistor 2a and the ground in order to filter the signal that arrives from 2a, and with means for protection against overvoltages, such as for example the Zener diode D2, in which the anode terminal is connected to the gate terminal of the MOSFET Q1 and the cathode terminal is connected to the voltage source Vcc.

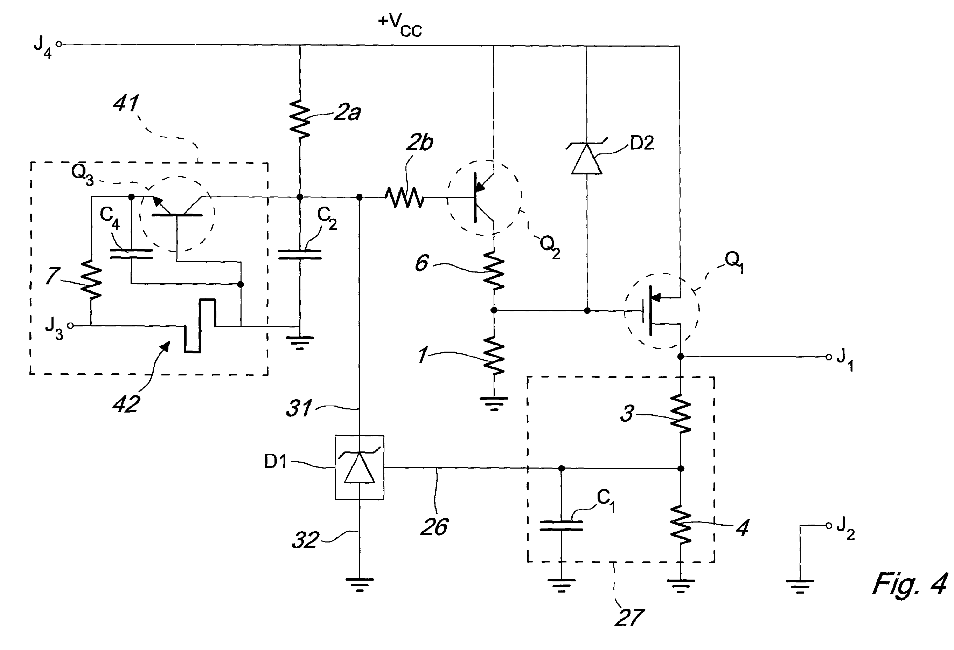

With reference to Figure 4, the PWM control circuit can optionally comprise current control means for interrupting the flow of current to the load when the maximum current in said load increases beyond a preset value. The current control means are connected, in particular, between the base terminal of the transistor Q2 and the ground, and comprise a bipolar transistor Q3 of the n-p-n type and a shunt 42 connected between the base terminal and the emitter terminal of Q3 by means of a resistor 7.

A capacitor C4 is connected in parallel to the base-emitter junction of the transistor Q3, in order to stabilize the voltage across the junction and optimize the response to an increase in current toward the terminal J3 sensed by the shunt 42.

In Figure 4, J3 and J4 designate the two input connection terminals.

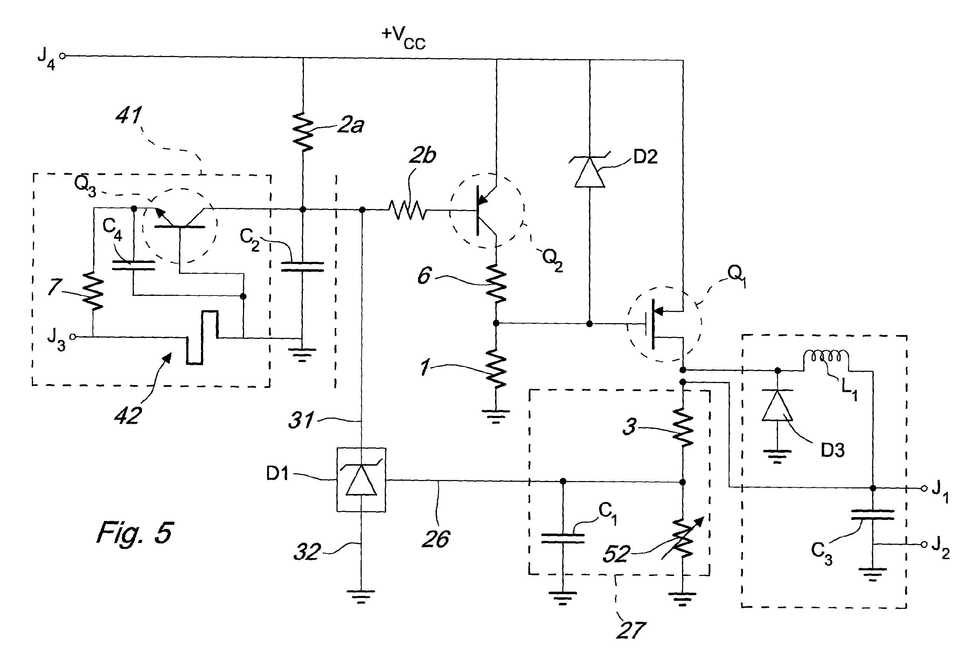

Figure 5 illustrates a variation of the PWM control circuit, in which at the output of the circuit there is a filtering block 51 for generating a constant voltage between the output terminals, designated by J1 and J2; the filtering block 51 is therefore arranged upstream of the load and preferably comprises an inductor L1, a third capacitor C3, and a diode D3, which are connected to the transistor Q1 so as to form a DC-DC switching converter.

The circuit according to the variation of Figure 5 further comprises a varistor 52 in parallel to the capacitor C1 in order to vary the value of the constant voltage generated in output.

The operation of the PWM control circuit is now described starting from the situation in which the power supply means 11 are deactivated; in this case, all the switches are off and in particular the gate terminal of Q1 is connected to the ground. When the power supply means 11 are switched on, the MOSFET immediately enters the linear operation range, because its source terminal rapidly increases in voltage, while the gate terminal remains at approximately zero potential. Thanks to the protective Zener diode D2, the voltage between the gate and the source of Q1 remains limited to the nominal voltage of the Zener diode D2.

When Q1 switches on, the voltage across the load 13 increases rapidly. With a delay that is approximately equal to the product between the value of the resistance of the resistive means 3 and the value of the capacity of C1, the voltage distributed by the resistive means 3 and 4 is read by the diode device D1 across the reference terminal 26.

By sizing the voltage divider constituted by the resistive means 3 and 4, it is possible to obtain a voltage between the reference terminal 26 and the ground that is equal to the threshold voltage of the diode device D1; in the TL431 device, the threshold voltage is 2.5 V.

The value of the power supply Vcc must be higher than the threshold voltage of the diode device D1; in particular, using R3 and R4 to designate respectively the values of the resistances of the resistive means 3 and 4, the minimum value of the power supply voltage must be:

$$Vcc \mid_{min} = \frac{(R3 + R4)}{R4} 2.5V.$$

When the diode device D1 is switched on upon reaching the treshold voltage, it draws current from the base terminal of the transistor Q2, which being of the p-n-p type is in turn switched on, reaching saturation.

The transistor Q2 then injects current into the first resistive means 1, rapidly increasing the voltage of the gate terminal of the transistor Q1 up to a value that is close to the value Vcc and thus switching off said transistor Q1. When the switch Q1 opens, the voltage across the load 13 decreases to the value of the ground voltage, and the capacitor C1 is discharged onto the resistor 4. The discharge of the capacitor C1 causes a reduction in the value of the voltage applied between the reference terminal 26 and the ground, and when this value drops below 2.5 V the switch D1 opens.

Due to the opening of the switch D1, the transistor Q2 switches off; accordingly, the switch Q1 is closed again and the voltage on the load is increased again to a value approximately equal to Vcc. The opening/closure cycle of the switches is then repeated.

The circuit just described therefore allows to obtain on the output load a voltage that oscillates between to values according to a time-dependent behavior that is very similar to a square wave. The average voltage across the load is constant, regardless of the value of the power supply voltage Vcc; it can be noted that a variation in the value of Vcc changes the peak value and the duty cycle of the square wave but does not change the average value.

The switching frequency can instead be regulated according to the delay that can be evaluated from the product of R3 and the value of the capacitance C of the capacitor C1. The switching frequency must be sized appropriately according to the typical requirements of switched circuits; in particular, it must not be too high in order to avoid excessive switching losses, and must not be too low, especially because when the load is a lamp one prefers to avoid making the oscillating behavior of the power supply of the load detectable by a user.

For example, it has been found that with a lamp supplied at 50 Hz, the human eye perceives the oscillation and audible humming is produced and persists up to power supplies at 2-3 kHz.

With reference to Figure 4, a sudden increase in current arriving from the power supply is sensed by the shunt 42, which owing to its resistance increases the voltage across its terminals, consequently increasing the base-emitter voltage of the n-p-n bipolar transistor Q3.

The switching on of Q3 entails a rapid closure of the switch Q2 and therefore an interruption of the supply of current to the load 13, which is thus safeguarded.

The PWM control circuit according to the invention can become an adjustable constant voltage source, according to the variation proposed in Figure 5. The filtering stage 51 is used to filter the high-frequency spectral components so as to produce a constant voltage in output.

The output voltage value can be regulated by means of the varistor 52: a variation in the value of the resistance of the varistor 52 entails a change in the relation between the average output voltage and the threshold voltage of the diode device D1 (which is fixed for example at 2.5 V). The resulting adjustable voltage source can be used as a regulator in electronic applications.

In practice it has been found that the PWM control circuit according to the present invention fully achieves the intended aim, since it allows to control low-voltage loads while maintaining a high efficiency.

Below the threshold power supply voltage Vcc|_{min}, the losses are mainly due to the MOSFET transistor Q1, since the supply voltage is simply transferred onto the load, and efficiency exceeds 99%.

In the steady state, instead, thanks to the particular combination of the components used, it is possible to achieve maximum efficiencies of over 80%: in this case, the losses are mainly due to switching and the exact value of the efficiency also depends on the power supply voltage and on the load.

Moreover, it has been found that the low number of components used not only allows to reduce manufacturing costs considerably but also allows to reduce the dimensions in the case of on-board or integrated circuit solutions; the circuit is therefore particularly applicable in portable battery-operated systems.

Therefore, the scope of the protection of the claims must not be limited by the illustrations or by the preferred embodiments given in the description as examples; rather, the claims must comprise all the patentable novelty characteristics that reside in the present invention, including all the characteristics that would be treated as equivalent by the person skilled in the art.

The invention thus conceived is in fact susceptible of numerous modifications and variations, all of which are within the scope of the inventive concept.

In practice, the materials used, as well as the contingent shapes and the dimensions, may be any according to requirements.

Where technical features mentioned in any claim are followed by reference signs, those reference signs have been included for the sole purpose of increasing the intelligibility of the claims and accordingly such reference signs do not have any limiting effect on the scope of each element identified by way of example by such reference signs.

## Claims

1. A PWM control circuit, comprising a load in output to said PWM control circuit, power supply means for generating a voltage value and means for regulating the voltage on said load, **characterized in that** it comprises means for reading the voltage on said load which are connected between said load and said voltage regulation means, said voltage regulation means comprising means for connecting said load to said power supply means at specific times, according to the voltage read by said voltage reading means.

2. The PWM control circuit according to claim 1, **characterized in that** said means for connecting said load to said power supply means comprise a first switch and a second switch, said first switch being connected between said power supply means and said load in order to connect the load to said power supply means at preset times, said second switch being connected between said power supply means and said first switch in order to control said first switch, said reading means being connected between said second switch and said load in order to control said second switch according to the voltage read by said reading means.

3. The PWM control circuit according to claim 2, **characterized in that** said first switch and said second switch are of three-pole type, said first switch and said second switch comprising respectively a first activation pole for opening or closing said first switch and a second activation pole for opening or closing said second switch, said second switch being connected to said first switch by means of said first activation pole, said reading means being connected to said second switch by way of said second activation pole.

4. The PWM control circuit according to claim 3, **characterized in that** said first switch comprises a MOSFET transistor and said second switch comprises a bipolar transistor, said MOSFET transistor comprising a gate terminal, a source terminal and a drain terminal, said first activation pole comprising said gate terminal, said bipolar transistor comprising a base terminal, a collector terminal and an emitter terminal, said second activation pole comprising said base terminal.

5. The PWM control circuit according to claim 4, **characterized in that** said MOSFET transistor is of the p-channel type and said bipolar transistor is of the p-n-p type, said source terminal being connected to said power supply means, said drain terminal being connected to said load and said gate terminal being connected to the ground across a first resistive means, said p-n-p bipolar transistor being connected to said power supply means across said emitter terminal and across a second resistive means that is connected to said base terminal, said collector terminal being connected to said gate terminal.

6. The PWM control circuit according to claim 3, **characterized in that** said reading means comprise a third switch, which is connected to said load across capacitive means and is connected to said second activation pole in order to open or close said second switch, said capacitive means comprising at least one first capacitor and resistive means.

7. The PWM control circuit according to claim 6, **characterized in that** said third switch is of the three-pole type, said third switch comprising a third activation pole for opening or closing said third switch, said third activation pole being connected to said capacitive means.

8. The PWM control circuit according to claim 5 and 7, **characterized in that** said third switch comprises a Zener diode device of the voltage reference type, said Zener diode device comprising a cathode terminal, an anode terminal and a reference terminal, said third activation pole comprising said reference terminal, said cathode terminal being connected to said base terminal and said anode terminal being connected to the ground.

**9.** The PWM control circuit according to any of the preceding claims, **characterized in that** it comprises a filtering block that is connected in output to said PWM control circuit and upstream of said load, in order to produce a constant voltage on said load, said capacitive means comprising a variable-resistance resistor for varying the constant voltage applied to said load.

**10.** The PWM control circuit according to claim 5, **characterized in that** said reading means furthermore comprise current control means that are connected between said second activation pole and the ground in order to close said second switch when the current in said load exceeds a preset value, said current control means comprising a bipolar transistor of the n-p-n type, which is connected by means of its collector terminal to said second activation pole, and a shunt which is connected to the base-emitter junction of said bipolar transistor of the n-p-n type in order to activate said n-p-n bipolar transistor and therefore interrupt the supply of current to said load.

Fig. 1

Fig. 2

EP 1 422 814 A1

Fig. 3

Fig. 4

EP 1 422 814 A1

+V<sub>CC</sub>

Fig. 5

EP 1 422 814 A1

**European Patent Office**

# EUROPEAN SEARCH REPORT

Application Number

EP 02 42 5707

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 456 050 B1 (AGIMAN DAN) 24 September 2002 (2002-09-24) | 1-7,9 | H02M3/156 H03K7/08 |
| Y | * column 1 - column 2; figures 1,2 * | 8,10 | |
| Y | L. HAYES ET AL.: "AND8024/D, Application Note, Off-line Critical Conduction Switching Power Supply with Voltage and Current Limiting " SEMICONDUCTOR COMPONENTS INDUSTRIES, [Online] September 2000 (2000-09), XP002251781 Phoenix,AZ,US Retrieved from the Internet: <URL:http://www.onsemi.com/pub/Collateral/ AND8024-D.PDF> [retrieved on 2003-08-20] * page 1 - page 2; figure 1 * | 8,10 | |
| X | WO 98 24170 A (BROCKEL BERTOLD ;SIEMENS AG (DE)) 4 June 1998 (1998-06-04) * the whole document * | 1-10 | |

TECHNICAL FIELDS SEARCHED (Int.Cl.7)

H02M
H03K

The present search report has been drawn up for all claims

| Place of search | Date of completion of the search | Examiner |
|---|---|---|
| THE HAGUE | 20 August 2003 | Jepsen, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 02 42 5707

This annex lists the patent family members relating to the patent documents cited in the above-mentioned European search report.
The members are as contained in the European Patent Office EDP file on
The European Patent Office is in no way liable for these particulars which are merely given for the purpose of information.

20-08-2003

| Patent document cited in search report | Publication date | Patent family member(s) | Publication date |
|---|---|---|---|
| US 6456050 B1 | 24-09-2002 | NONE | |
| WO 9824170 A | 04-06-1998 | WO 9824170 A1 | 04-06-1998 |

EPO FORM P0459

For more details about this annex : see Official Journal of the European Patent Office, No. 12/82